Europäisches Patentamt

European Patent Office

Office européen des brevets

(11) Veröffentlichungsnummer: **0 298 377**
**A1**

(12) **EUROPÄISCHE PATENTANMELDUNG**

(21) Anmeldenummer: 88110505.0

(22) Anmeldetag: 30.06.88

(51) Int. Cl.⁴: **G01R 1/067 , H01R 11/18**

(30) Priorität: 03.07.87 DE 8709234 U

(43) Veröffentlichungstag der Anmeldung:
**11.01.89 Patentblatt 89/02**

(84) Benannte Vertragsstaaten:
**AT BE CH DE ES FR GB GR IT LI LU NL SE**

(71) Anmelder: **Nixdorf Computer
Aktiengesellschaft
Fürstenallee 7
D-4790 Paderborn(DE)**

(72) Erfinder: **Arampoglou, Savvas
Am Fasanengarten 2
D-6277 Bad Camberg(DE)**
Erfinder: **Hohmann, Heinz H., Dr.
Dietrichstrasse 58
D-4790 Paderborn 2(DE)**

(74) Vertreter: **Schaumburg, Thoenes &
Englaender
Mauerkircherstrasse 31 Postfach 86 07 48
D-8000 München 80(DE)**

(54) Kontaktstiftanordnung.

(57) Die Erfindung betrifft eine Kontaktstiftanordnung, wie sie beispielsweise für die Erstellung von sogenannten Prüfadaptern zur Prüfung von elektronischen Leiterplatten verwendet werden; sie umfassen eine in eine Prüfplatte einsetzbare Hülse (2) mit einem an deren unterem Ende angeordneten wire-wrap-post (14) und einem in der Hülse (2) federnd verschiebbar gelagerten Kontaktstift (16), welcher mit der Hülse (2) in elektrisch leitendem Kontakt steht. Erfindungsgemäß wird dieser Kontakt über ein in einer Kammer (32) der Hülse (2) befindliches, einen Schaftabschnitt (26) des Kontaktstiftes (16) umgebendes fließfähiges Kontaktmittel (34) hergesetellt. Diese Anordnung gewährleistet einen verschließarmen Aufbau und einen über eine lange Lebensdauer gleichbleibenden guten Übergangswiderstand. Als Kontaktmittel (34) dienen z.B. Leitpasten, flüssige Metalle oder Leitpulver.

# Kontaktstiftanordnung

Die Neuerung betrifft eine Kontaktstiftanordnung der im Oberbegriff des Anspruches 1 genannten Art.

Derartige Kontaktstiftanordnungen werden beispielsweise zur Erstellung von Prüfplatten zur Prüfung von elektronischen Leiterplatten oder dergleichen verwendet. Die Hülsen werden in die Prüfplatten eingesetzt und über am unteren Hülsenende angeordnete Kontaktpfosten (wire-wrap-posts) mit einer Prüfschaltung verbunden. Die im allgemeinen federnd gelagerten Kontaktstifte ragen mit ihrem Kontaktende aus dem anderen Hülsenende heraus. Beim Prüfvorgang legen sie sich mit ihrem Kontaktende federnd gegen den zugeordneten Prüfpunkt der Leiterplatte an.

An die Kontaktstiftanordnungen werden unter anderem folgende Anforderungen gestellt:
- Der Durchgangswiderstand für das zu übertragende Signal soll möglichst klein sein;
- die elektrischen Eigenschaften der Kontaktstiftanordnung sollen während der Lebensdauer möglichst unverändert bleiben, d.h. es sollen keine Veränderungen des Durchgangswiderstandes auftreten;
- die Lebensdauer der Kontaktstiftanordnung soll möglichst groß sein;
- die Materialien und Oberflächenbeschichtungen der Einzelteile der Kontaktstiftanordnung sollen möglichst einfach sein.

In dieser Hinsicht ist vor allem die Kontaktgabe zwischen dem beweglichen Kontaktstift und der Hülse kritisch. Durch ungenaue Passungen können schon die neuen Kontaktstiftanordnungen unterschiedliche und zu hohe Durchgangswiderstände aufweisen. Infolge von Verschleiß, Korrosion und Verschmutzung kann sich darüber hinaus der Durchgangswiderstand während des Einsatzes der Kontaktstiftanordnung beträchtlich erhöhen, so daß ein Austausch der Kontaktstiftanordnung bzw. einzelner Komponenten derselben erforderlich wird.

Es ist bereits eine Kontaktstiftanordnung der im Oberbegriff des Anspruches 1 genannten Art bekannt, bei welchem der Kontaktstift mittels eines daran ausgebildeten Kolbenabschnittes in der Hülse geführt ist, wobei die Kolbenfläche einerseits und die Innenfläche der Hülse andererseits die Kontaktflächen für die Signalübertragung bilden (DE-OS 31 03 077). Bei dieser bekannten Anordnung sind die Führungsflächen zur Führung des beweglichen Kontaktstiftes gleichzeitig die Kontaktflächen für die Signalübertragung. Um eine gute Signalübertragung bei geringem Durchgangswiderstand sicherzustellen, ist es deshalb erforderlich, daß der Kolben mit geringer, vorgegebener Toleranz genau in die Hülse eingepaßt ist, so daß der Kolben ständig möglichst großflächig an der Hülseninnenseite anliegt. Ein hoher Passungsaufwand ist jedoch immer mit hohen Herstellungskosten verbunden. Da andererseits die Kontaktstiftanordnungen in großer Zahl verwendet werden und deshalb als preiswerte Massenartikel hergestellt werden sollen, ist es unvermeidlich, daß Toleranzabweichungen vorkommen. Dadurch ergeben sich entweder zu enge Passungen und damit eine unerwünschte Schwergängigkeit des Kontaktstiftes in der Hülse, oder zu weite Passungen und damit zu hohe, vom vorgegebenen Wert abweichende Widerstände.

Da zudem an den relativ zueinander bewegten Führungsflächen ein Verschleiß, Korrosion und Verschmutzung unvermeidbar sind, ist auch eine Änderung der elektrischen Eigenschaften, d.h. eine schädliche Erhöhung des Durchgangswiderstandes während der Lebensdauer der Kontaktstiftanordnung unvermeidlich. Deshalb müssen Kontaktstiftanordnungen der bekannten Art bzw. einzelne Komponenten derselben häufig nach einer verhältnismäßig kurzen Einsatzzeit ausgetauscht werden, weil ihre Durchgangswiderstände eine vorgegebene Toleranzgrenze überschritten haben.

Um die beschriebenen Nachteile bekannter Kontaktstiftanordnungen in Grenzen zu halten, sind für die Führungs- und Kontaktflächenpaarung schon besondere Materialpaarungen vorgeschlagen worden, die entweder den Verschleiß dieser Flächen ganz allgemein soweit wie möglich reduzieren oder die es erlauben, eines der zusammenwirkenden Teile, beispielsweise den Kontaktstift, gezielt zum Verschleiß- und Austauschteil zu machen ( DE-P 36 04 717 ). Die geforderten mechanischen und elektrischen Eigenschaften werden im allgemeinen nur mit einer beschränkten Anzahl von Materialpaarungen zufriedenstellend erfüllt, die im allgemeinen teuer sind. Um den Preis der Kontaktstiftanordnung nicht durch Verwendung teurer Materialien zu sehr zu erhöhen, werden die Hülse und/oder der Kontaktstift im allgemeinen aus einem billigeren Grundmaterial hergestellt und dann in aufwendiger Weise mit einer geeigneten Oberflächenbeschichtung versehen.

Es ist die Aufgabe der vorliegenden Neuerung, eine Kontaktstiftanordnung der im Oberbegriff des Anspruches 1 genannten Art zu schaffen, die einen geringen, auch nach längerem Einsatz weitgehend unveränderlichen Durchgangswiderstand und damit eine hohe Lebensdauer aufweist, wobei auf die Verwendung von aufwendigen und teueren Materialien für die Herstellung bzw. Beschichtung der Einzelteile verzichtet werden soll.

Diese Aufgabe ist neuerungsgemäß durch die im Kennzeichen des Anspruches 1 beschriebenen Merkmale gelöst.

Der Kontakt zwischen dem Kontaktstift und der Hülse erfolgt nicht mehr direkt über gleitend aneinander liegende Führungsflächen, sondern über ein fließfähiges Kontaktmittel; die Aufgaben der Führung des Kontaktstiftes in der Hülse einerseits und der Kontaktgabe zwischen diesen Bauteilen andererseits sind voneinander getrennt. Daraus ergeben sich folgende Vorteile:

- das zwischen Kontaktflächen des Kontaktstiftes einerseits und der Hülse andererseits befindliche fließfähige Kontaktmittel liegt an diesen Kontaktflächen immer gleichmäßig satt an, so daß sich ein guter, vorher bestimmbarer Durchgangswiderstand ergibt;

- da die von dem Kontaktmittel benetzten Kontaktflächen keinem Verschleiß unterliegen, ändert sich der Durchgangswiderstand während der Lebensdauer der Kontaktstiftanordnung nicht; selbst wenn ein Verschleiß stattfinden sollte, führt das zu keiner Änderung der wirksamen Kontaktfläche, so daß die Lebensdauer der Kontaktstiftanordnung jedenfalls nicht durch eine Änderung der elektrischen Eigenschaften verkürzt wird;

- die Kontaktflächen einerseits und die Führungsflächen andererseits können jeweils optimal an ihre Aufgaben angepaßt werden, so daß nicht nach teuren Materialien für die zusammenwirkenden Komponenten bzw. deren Beschichtung gesucht werden muß, die die Anforderungen in beiden Aufgabenbereichen erfüllen.

In einer Ausgestaltung der Neuerung ist vorgesehen, daß das Kontaktmittel eine Leitpaste ist. Derartige Leitpasten bestehen beispielsweise aus einem pastenartigen Trägermaterial, welches mit einem Pulver aus elektrisch leitfähigem Material vermischt ist (siehe z.B. DE-PS 26 17 226).

In anderer Ausgestaltung der Neuerung ist vorgesehen, daß das Kontaktmittel ein flüssiges Metall ist. Als Beispiele seien Quecksilber oder Gallium genannt. Der Vorteil von Quecksilber ist darin zu sehen, daß es bei allen praktisch vorkommenden Raumtemperaturen flüssig bleibt und daß es verhältnismäßig preiswert ist. Nachteilig ist dagegen seine Giftigkeit und sein hohes Gewicht.

Gallium ist vom Gesichtspunkt der Umweltverträglichkeit weniger problematisch. Es ist jedoch teurer und hat seinen Schmelzpunkt bei 30° C. Obwohl reines flüssiges Gallium relativ stark unterkühlbar ist, besteht unter Umständen doch die Notwendigkeit, Kontaktstiftanordnungen mit Gallium als Kontaktmittel oberhalb der Erstarrungstemperatur zu lagern, wenn sie kurzfristig funktionsfähig sein sollen.

In einer anderen Ausgestaltung der Neuerung ist vorgesehen, daß das Kontaktmittel ein Pulver, beispielsweise Graphitpulver oder Metallpulver ist.

Zur Aufnahme des Kontaktmittels ist neuerungsgemäß in der Hülse eine durch Stirnwände begrenzte Kontaktmittelkammer ausgebildet; durch diese Kontaktmittelkammer ist ein mit dem Kontaktstift verbundener Schaftabschnitt hindurch geführt, wobei die Durchführung durch die Stirnwände jeweils für das Kontaktmittel dicht ausgebildet sind. Der zwischen dem Schaftabschnitt und der Hülseninnenwand gebildete Ringraum ist mit dem Kontaktmittel ausgefüllt.

In weiterer Ausgestaltung der Neuerung ist vorgesehen, daß die Kontaktmittelkammer in einem Endteil der Hülse ausgebildet ist, wobei eine Stirnwand als eine mit einer Durchtrittsöffnung für den Schaftabschnitt des Kontaktstiftes versehene Querwand ausgebildet und die andere Stirnwand durch einen das Hülsenende verschließenden, mit einer axialen Aufnahmeöffnung zur Schiebeführung des Schaftabschnittes versehenen Verschlußpfropfen gebildet ist. Zumindest der durch die Querwand gebildeten Stirnwand ist eine an dieser dichtend anliegende, den Schaftabschnitt abdichtend umgebende Dichtung zugeordnet. Die Aufnahmeöffnung im Verschlußpfropfen kann hingegen so ausgebildet sein, daß sie keinen Durchgang nach Außen aufweist, so daß sich dann eine Abdichtung erübrigt, wie anhand des Ausführungsbeispiels noch genauer dargelegt wird.

In weiterer Ausgestaltung der Neuerung ist auf der der Kontaktmittelkammer der Hülse abgewandten Seite der Querwand eine Führungskammer zur Führung eines am Kontaktstift ausgebildeten Führungskolbens vorgesehen. Der Führungskolben kann mit einem Material geringer Reibung, vorzugsweise mit Polytetrafluoräthylen beschichtet sein, so daß die Führungsflächen des Führungsstiftes bzw. der Hülse einen geringen Reibungswiderstand und einen geringen Verschleiß aufweisen.

Die Kontaktmittelkammer ist neuerungsgemäß vorzugsweise an dem der freien Kontaktspitze des Kontaktstiftes abgewandten Endteil der Hülse ausgebildet, wobei der das Hülsenende verschließende Verschlußpfropfen eine diesen axial durchsetzende Aufnahmeöffnung aufweist, in deren der Kontaktmittelkammer zugewandtes Ende das Schaftabschnittsende des Kontaktstiftes eintaucht und in deren anderes Ende ein die Aufnahmeöffnung dichtend verschließender Kontaktpfosten eingesetzt ist.

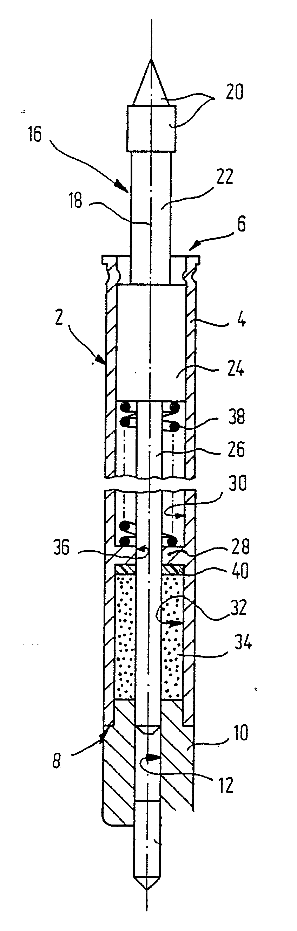

Ein Ausführungsbeispiel der Neuerung ist in der Zeichnung dargestellt und im folgenden näher beschrieben. Die Figur zeigt in einer Längsschnittdarstellung eine Kontaktstiftanordnung mit einer Hülse, einem darin verschiebbar gelagerten Kontaktstift und einem fließfähigen Kontaktmittel für die Signalübertragung zwischen Kontaktstift und Hülse.

Die Hülse 2 umfaßt ein Mantelrohr 4 aus einem elektrisch leitendem Material oder mit einer elektrisch leitenden Oberflächenbeschichtung. Die Hülse 2 ist an ihrem oberen Ende 6 offen, an ihrem unteren Ende 8 jedoch durch einen Verschlußpfropfen 10 verschlossen. Der Verschlußpfropfen 10 weist eine diesen axial durchsetzende Aufnahmeöffnung 12 auf, in deren der Hülse 2 fernes Ende ein diese Aufnahmeöffnung 12 dichtend verschließender Kontaktpfosten 14 eingesetzt ist. Auch der Verschlußpfropfen 10 und der Kontaktpfosten 14 sind jeweils aus einem elektrisch leitendem Material gefertigt oder mit einem derartigen Material beschichtet.

Die Hülse 2 ist dazu bestimmt, in eine Prüfplatte oder einen sogenannten Prüfadapter eingesetzt zu werden. Über den Kontaktpfosten 14 kann die Hülse 2 mit einer Prüfschaltung verbunden werden, wie allgemein bekannt ist und deshalb nicht näher beschrieben zu werden braucht.

In der Hülse 2 ist ein Kontaktstift 16 in Richtung seiner Längsachse 18 verschiebbar angeordnet. Der Kontaktstift 16 umfaßt einen Kontaktkopf 20, einen daran anschließenden Schaftabschnitt 22, einen Kolbenabschnitt 24 und einen wei teren Schaftabschnitt 26. Der Kontaktkopf 20 ist dazu bestimmt, mit dem Prüfpunkt eines zu prüfenden Gerätes, beispielsweise einer Leiterplatte, in Kontakt gebracht zu werden. Der Kolbenabschnitt 24 dient zur axialen Führung des Kontaktstiftes 16 in der Hülse 2. Der obere Schaftabschnitt 22 ist entsprechend den auf den Prüfstift 16 einwirkenden mechanischen Kräften dimensioniert. Der untere Schaftabschnitt 26 dient zur Führung des Kontaktstiftes 16 und zur Übertragung elektrischer Signale auf die Hülse 2, wie weiter unten näher beschrieben wird.

Der Kolbenabschnitt 24, welcher nur zur Längsführung des Kontaktstiftes 16 in der Hülse 2, nicht jedoch zur Signalübertragung dient, ist vorzugsweise mit einem Material geringer Reibung, beispielsweise Polytetrafluoräthylen, beschichtet. Da dieses Material sehr reibungsarm ist, ist auch ein nur geringer Verschleiß zu erwarten, so daß insofern eine hohe Lebensdauer der Kontaktstiftanordnung gegeben ist.

Der Schaftabschnitt 26, auf den im wesentlichen keine mechanischen Kräfte wirken, kann gegenüber dem oberen Schaftabschnitt 22 und dem Kolbenabschnitt 24 wesentlich dünner ausgeführt sein. Das Mantelrohr 4 ist durch eine Querwand 28 unterteilt. Der in der Figur oberhalb der Querwand 28 liegende Teil des Mantelrohrs 4 bildet eine Führungskammer 30 zur Führung des Kolbenabschnittes 24. Der unterhalb der Querwand 28 liegende Teil des Mantelrohrs 4 bildet eine Kontaktmittelkammer 32 zur Aufnahme eines fließfähigen Kontaktmittels 34.

Die Querwand 28 weist eine Durchtrittsöffnung 36 für den Schaftabschnitt 26 auf. Wie die Figur erkennen läßt, durchsetzt der Schaftabschnitt 26 die ganze Kontaktmittelkammer 32 und taucht auch bei der dargestellten, ausgefahrenen Stellung des Kontaktstiftes 16 noch in die Aufnahmeöffnung 12 des Ver schlußpfropfens 10. Der Schaftabschnitt 26 ist demnach durch die Querwand 28 und die Aufnahmeöffnung 12 in Längsrichtung geführt und verhindert damit ein Verkanten des Kolbenabschnittes 24 in der Führungskammer 30.

Das Kontaktmittel 34 kann beispielsweise eine elektrisch leitfähige Paste, ein flüssiges Metall oder ein elektrisch leitfähiges Pulver sein; es füllt die Kontaktmittelkammer vollständig aus. Da es einerseits am Schaftteil 26, andererseits an der Innenwand der Kontaktmittelkammer 34 immer vollständig benetzend anliegt, ist eine bestmögliche,definierte Kontaktübertragung vom längsbeweglichen Schaftabschnitt 26 zur Hülse 2 gewährleistet.

Die durch die Innenseite der Durchtrittsöffnung 36 und der Aufnahmeöffnung 12 gebildeten, mit dem Schaftabschnitt 26 zusammenwirkenden Kontaktflächen fallen demgegenüber nicht ins Gewicht. Um einen Signalübergang an diesen Stellen jedoch auch noch auszuschließen, können die Innenseite der Durchgangsöffnung 36 und der Aufnahmeöffnung 12,jedenfalls soweit wie der Schaftabschnitt 26 in diese eintaucht, mit einer isolierenden Beschichtung versehen sein.

In der Führungskammer 30 ist eine den Schaftabschnitt 26 umgebende Feder 38 angeordnet, die sich einerseits gegen die Querwand 28, andererseits gegen die Unterseite des Kolbenabschnittes 24 abstützt. Diese Feder drückt den Kontaktstift 16 in bekannter Weise in seine ausgefahrene Stellung; im Einsatz wird der Kontaktstift 16 gegen die Kraft der Feder 38 mehr oder weniger weit in die Hülse 2 hineingeschoben um eine Signalübertragung durch die Feder 38, die wegen der unterschiedlichen Induktivität infolge unterschiedlicher Zusammendrückung der Feder veränderlich wäre, auszuschließen, ist diese Feder 38 gegenüber dem Kontaktstift 16 und/oder der Hülse 2 elektrisch isoliert.

An der Unterseite der Querwand 28 ist eine den Schaftabschitt 26 abdichtend umgebende Dichtung 40 angeordnet, die ein Übertreten des Kontaktmittels 34 in die Führungskammer 30 verhindert. Eine ähnliche Dichtung kann, falls erforderlich, auf der der Kontaktmittelkammer 34 zugewandten Stirnfläche des Verschlußpfropfens 10 vorgesehen sein.

## Ansprüche

1. Kontaktstiftanordnung mit einer Hülse und einem in der Hülse verschiebbar gelagerten Kontaktstift, welcher mit der Innenseite der Hülse in elektrischem Kontakt steht, dadurch **gekennzeichnet,** daß der Kontakt über ein fließfähiges Kontaktmittel (34) erfolgt.

2. Kontaktstiftanordnung nach Anspruch 1, dadurch **gekennzeichnet,** daß das Kontaktmittel (34) eine Leitpaste ist.

3. Kontaktstiftanordnung nach Anspruch 1, dadurch **gekennzeichnet,** daß das Kontaktmittel (34) ein flüssiges Metall, insbesondere Quecksilber oder Gallium ist.

4. Kontaktstiftanordnung nach Anspruch 1, dadurch **gekennzeichnet,** daß das Kontaktmittel (34) ein Pulver, insbesondere Graphitpulver oder Metallpulver ist.

5. Kontaktstiftanordnung nach einem der Ansprüche 1 bis 4, dadurch **gekennzeichnet,** daß in der Hülse (2) eine durch Querwände (28, 10) begrenzte Kontaktmittelkammer (32) ausgebildet ist, daß ein mit dem Kontaktstift (16) verbundener Schaftabschnitt (26) abdichtend durch die Kontaktmittelkammer (32) hindurch geführt ist und daß der zwischen dem Schaftabschnitt (26) und der Hülsenwand gebildete Ringraum mit dem Kontaktmittel (34) ausgefüllt ist.

6. Kontaktstiftanordnung nach Anspruch 5, dadurch **gekennzeichnet,** daß die Kontaktmittelkammer (32) in einem Endteil der Hülse (2) ausgebildet ist, wobei eine Stirnwand der Kontaktmittelkammer (32) als eine mit einer Durchtrittsöffnung (36) für den Schaftabschnitt (26) des Kontaktstiftes (16) versehene Querwand (28) ausgebildet und die andere Stirnwand durch einen das Hülsenende verschließenden, mit einer axialen Aufnahmeöffnung (12) zur Schiebeführung des Schaftabschnittes (26) versehenen Verschlußpfropfen (10) gebildet ist.

7. Kontaktstiftanordnung nach Anspruch 6, dadurch **gekennzeichnet,** daß zumindest der Querwand (28) eine an dieser dichtend anliegende, den Schaftabschnitt (26) abdichtend umgebende Dichtung (40) zugeordnet ist.

8. Kontaktstiftanordnung nach einem der Ansprüche 5 bis 7, dadurch **gekennzeichnet,** daß auf der der Kontaktmittelkammer (32) der Hülse (2) abgewandten Seite der Querwand (28) eine Führungskammer (30) zur Führung eines am Kontaktstift (16) ausgebildeten Kolbenabschnittes (24) vorgesehen ist, wobei insbesondere der Kolbenabschnitt (24) mit einem Material geringer Reibung, vorzugsweise mit Polytetrafluoräthylen, beschichtet ist.

9. Kontaktstiftanordnung nach einem der Ansprüche 6 bis 8, dadurch **gekennzeichnet,** daß die Kontaktmittelkammer (32) im Bereich des dem Kontaktkopf (20) des Kontaktstiftes (16) abgewandten Hülsenendes (8) ausgebildet ist, wobei der das Hülsenende (8) verschließende Verschlußpfropfen (10) eine diesen axial durchsetzende Aufnahmeöffnung (12) aufweist, in deren der Kontaktmittelkammer (32) zugewandtes Ende das Ende des Schaftabschnittes (26) des Kontaktstiftes (16) eintaucht und in deren anderes Ende ein die Aufnahmeöffnung (12) dichtend verschließender Kontaktpfosten (14) (wire-wrap-post) eingesetzt ist.

10. Kontaktstiftanordnung nach Anspruch 9, dadurch **gekennzeichnet,** daß die Querwand (28) als Stützfläche für ein Ende einer in der Führungskammer (30) angeordneten, mit ihrem anderen Ende gegen den Kolbenabschnitt (24) des Kontaktstiftes (16) anliegenden Druckfeder (38) dient.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,Y P A | DE-A-3 604 717 (NIXDORF COMPUTER) * Zusammenfassung; Figur 1 * | 1 5-10 | G 01 R 1/067 H 01 R 11/18 |
| | --- | | |
| Y A | GB-A-1 234 159 (ELECTRICITY COUNCIL) * Anspruch 1; Figuren * | 1 3 | |
| | --- | | |
| A | US-A-4 643 843 (LOWDON) * Zusammenfassung * | 2 | |
| | --- | | |
| A | MEASUREMENT TECHNIQUE, Band 27, Nr. 9, September 1984, Seiten 805-806, Plenum Publishing Corporation, New York, US; V.A. D'YACHENKO et al.: "Multichannel mercury measurement contacts" * Seite 805, Absatz 2 * | 3 | |
| | --- | | |
| A | FR-A-2 426 987 (BENGT PETERSSON) * Seite 3, Zeilen 16-21; Figur 5 * | 4 | RECHERCHIERTE SACHGEBIETE (Int. Cl.4) |
| | --- | | |
| A | PATENT ABSTRACTS OF JAPAN, Band 10, Nr. 27 (E-378)[155]; & JP-A-60 187 237 (HITACHI SEISAKUSHO K.K.) 24-09-1985 | 8 | G 01 R H 01 R H 01 B |
| | ----- | | |

Der vorliegende Recherchenbericht wurde für alle Patentansprüche erstellt

| Recherchenort | Abschlußdatum der Recherche | Prüfer |
|---|---|---|
| DEN HAAG | 06-10-1988 | HARRISON R.J. |